# EUROPEAN PATENT APPLICATION

(11) **EP 4 757 521 A1**
(43) Date of publication of application: **10.06.2026**
(21) Application number: 25209140.0
(22) Date of filing: 16.10.2025
(51) Int. Cl.: H10B 12/00

(54) **MEMORY DEVICE**

(30) Priority: 03.12.2024 KR 20240177281
(71) Applicant: SK hynix Inc., Bubal-eub Icheon-si Gyeonggi-do 17336 (KR)
(72) Inventor: WON, Na Hye, Icheon-si, Gyeonggi-do (KR); KIM, Sung Soo, Icheon-si, Gyeonggi-do (KR); CHUNG, Woo Young, Icheon-si, Gyeonggi-do (KR); LEE, Min Yung, Icheon-si, Gyeonggi-do (KR)
(74) Representative: Isarpatent

(57) **Abstract**

A memory device according to embodiments of the present disclosure may comprise a word line buried in a substrate and extending in a first direction, a bit line contact disposed between word lines, contacting an active area of the substrate, and having at least a portion of a side surface concave toward a center in a second direction perpendicular to the first direction, and a gate capping layer including a first capping portion contacting an upper surface of the word line and a second capping portion positioned on the first capping portion, overlapping with at least a portion of the side surface of the bit line contact in the second direction, and having a width different from a width of the first capping portion.

## Description

### TECHNICAL FIELD

Embodiments of the present disclosure relate generally to a memory device.

### BACKGROUND

By their miniaturization, multi-functionality, and/or low manufacturing cost characteristics, memory devices are attracting attention as an important element in the electronics industry. As the electronics industry advances, memory devices are becoming increasingly highly integrated. For highly integrated memory devices, the width of the lines included in the memory devices are gradually decreasing, and the size of the memory cell is being decreased. This increases the difficulty of the process of forming memory cells.

### SUMMARY

Embodiments of the present disclosure provide a memory device capable of preventing process defects occurring during a manufacturing process of a memory device.

Objects of embodiments of the present disclosure are not limited to those set forth herein, and other unmentioned objects that would be apparent to one of ordinary skill in the art from the following description.

Embodiments of the present disclosure may provide a memory device comprising a word line buried in a substrate and extending in a first direction, a bit line contact disposed between word lines, contacting an active area of the substrate, and having at least a portion of a side surface concave toward a center in a second direction perpendicular to the first direction, and a gate capping layer including a first capping portion contacting an upper surface of the word line and a second capping portion positioned on the first capping portion, overlapping with at least a portion of the side surface of the bit line contact in the second direction, and having a width different from a width of the first capping portion.

Embodiments of the present disclosure may provide a memory device comprising a word line buried in a substrate and extending in a first direction, a bit line contact disposed between word lines, contacting an active area of the substrate, and having at least a portion of a side surface concave toward a center in a second direction perpendicular to the first direction, a gate capping layer overlapping with word line and having at least a portion overlapping with at least a portion of the side surface of the bit line contact in the second direction, and a buffer layer disposed on the gate capping layer and surrounding the bit line contact.

Embodiments of the present disclosure may provide a memory device comprising a word line buried in a substrate and extending in a first direction, a bit line contact disposed between word lines and contacting an active area of the substrate, a gate capping layer including a first capping portion contacting an upper surface of the word line and a second capping portion positioned on the first capping portion, a lower surface of the second capping portion being positioned higher than an upper surface of the substrate, and a buffer layer covering the second capping portion of the gate capping layer and surrounding the bit line contact.

According to embodiments of the present disclosure, it is possible to prevent process defects occurring during a manufacturing process of a memory device.

The effects of the embodiments of the present disclosure are not limited to the foregoing objects, and other effects will be apparent to one of ordinary skill in the art from the following detailed description.

### BRIEF DESCRIPTION OF THE DRAWINGS

The embodiments of the present disclosure will be more fully understood from the following detailed description and the accompanying drawings, which are provided for illustration only and are not intended to limit the embodiments.
FIG. 1 is a view illustrating a planar structure of a memory device according to embodiments of the present disclosure;
FIG. 2 is a view illustrating a cross-sectional structure of part I-I' of FIG. 1;
FIG. 3 is a view illustrating a cross-sectional structure of part II-II' of FIG. 1;
FIG. 4 is a view illustrating a cross-sectional structure of part III-III' of FIG. 1;
FIGS. 5 to 7 are enlarged views of portion 10 of FIG. 1 and portion 20 of FIG. 2;
FIG. 8 is a view illustrating another cross-sectional structure of part I-I' of FIG. 1;
FIG. 9 is a view illustrating another cross-sectional structure of part II-II' of FIG. 1;
FIGS. 10 and 11 are enlarged views of portion 30 of FIG. 8 and portion 40 of FIG. 9;
FIGS. 12 to 21 are views illustrating a method for manufacturing a memory device according to embodiments of the present disclosure; and
FIG. 22 is a view illustrating another method for manufacturing a memory device according to embodiments of the present disclosure.

### DETAILED DESCRIPTION

Hereinafter, embodiments of the present disclosure are described in detail with reference to the accompanying drawings. The same or substantially the same reference denotations are used to refer to the same or substantially the same elements throughout the specification and the drawings. Details of the known art or functions may be skipped when it is determined that the subject matter of the present disclosure may become unclear. As used herein, when a component "includes," "has," or "is composed of" another component, the component may add other components unless the component "only" includes, has, or is composed of' the other component. As used herein, the singular forms "a," "an," and "the" are intended to include the plural forms as well, unless the context clearly indicates otherwise.

Such denotations as "first," "second," "A," "B," "(a)," and "(b)," may be used in describing the components of the embodiments of the present disclosure. These denotations are provided merely to distinguish a component from another, and the essence, order, or number of the components is not limited by the denotations in light of order or sequence.

In describing the positional relationship between components, when two or more components are described as "connected", "coupled" or "linked", the two or more components may be directly "connected", "coupled" or "linked" ", or another component may intervene. Here, the other component may be included in one or more of the two or more components that are "connected", "coupled" or "linked" to each other.

When such terms as, e.g., "after", "next to", "after", and "before", are used to describe the temporal flow relationship related to components, operation methods, and fabricating methods, it may include a non-continuous relationship unless the term "immediately" or "directly" is used.

If a numerical value or its corresponding information (e.g., level, etc.) is mentioned for a component, it may be interpreted that the numerical value or its corresponding information includes a margin of error that may be caused by various factors (e.g., process factors, internal or external shocks, noise, etc.), even if it is not explicitly stated otherwise.

Hereinafter, various embodiments of the present disclosure will be described in detail with reference to accompanying drawings.

In the accompanying drawings, the three directions parallel to the upper surface of the substrate are defined as a first direction FD, a second direction SD, and a third direction TD, respectively, and the direction protruding vertically from the upper surface of the substrate is defined as a fourth direction VD. The first direction FD and the second direction SD may be substantially perpendicular to each other. The fourth direction VD is a direction perpendicular to the first direction FD, the second direction SD, and the third direction TD. In the following specification, 'vertical' or 'vertical direction' will be used as having substantially the same meaning as the fourth direction VD. The direction indicated by arrow in the drawings and the opposite direction indicate the same direction.

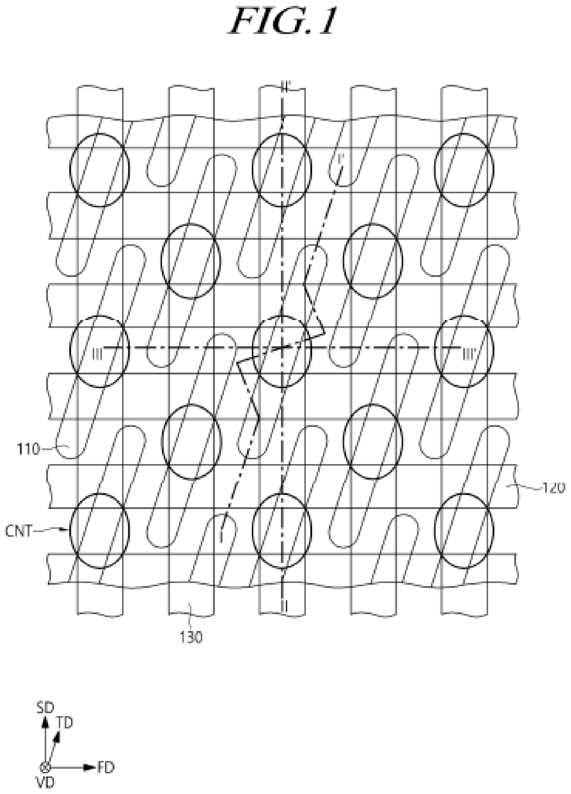

FIG. 1 is a view illustrating a planar structure of a memory device according to embodiments of the present disclosure.

Referring to FIG. 1, a memory device according to embodiments of the present disclosure includes an active area 110, a word line 120, and a bit line structure 130. The word line 120 extends in the first direction FD and crosses the active area 110. A plurality of word lines 120 may be disposed parallel to each other in the second direction SD. In an embodiment, two corresponding word lines 120 may cross one active area 110.

The bit line structure 130 extends in the second direction SD and crosses the active area 110. A plurality of bit line structures 130 may be disposed parallel to each other in the first direction FD. The bit line structures 130 cross the word lines 120. The bit line structures 130 may be orthogonal to the word lines 120. In an embodiment, a corresponding bit line structure 130 may cross one active area 110.

The bit line contact hole CNT may be disposed to overlap each of the active areas 110. The bit line contact hole CNT may correspond to one active area 110. The bit line contact hole CNT may be positioned near the center of the active area 110. The bit line contact hole CNT is positioned between the word lines 120. In an embodiment, at least a portion of the bit line contact hole CNT may overlap with the word line 120 in the second direction SD. The bit line contact hole CNT overlaps each of the bit line structures 130. In FIG. 1, the bit line contact hole CNT is illustrated as elliptical in plan view, but the shape of the bit line contact hole CNT is not limited thereto.

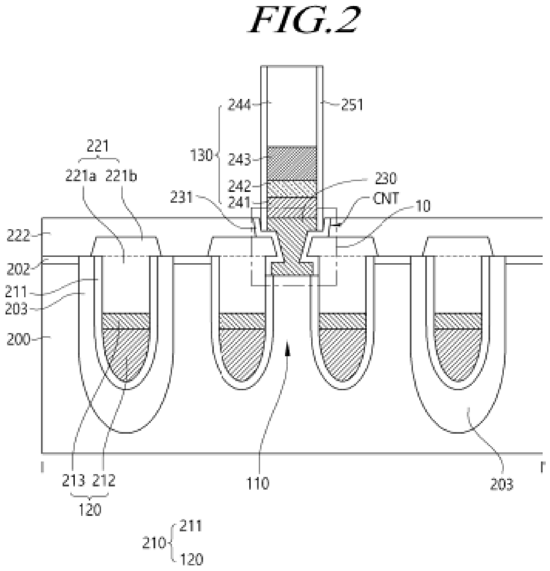

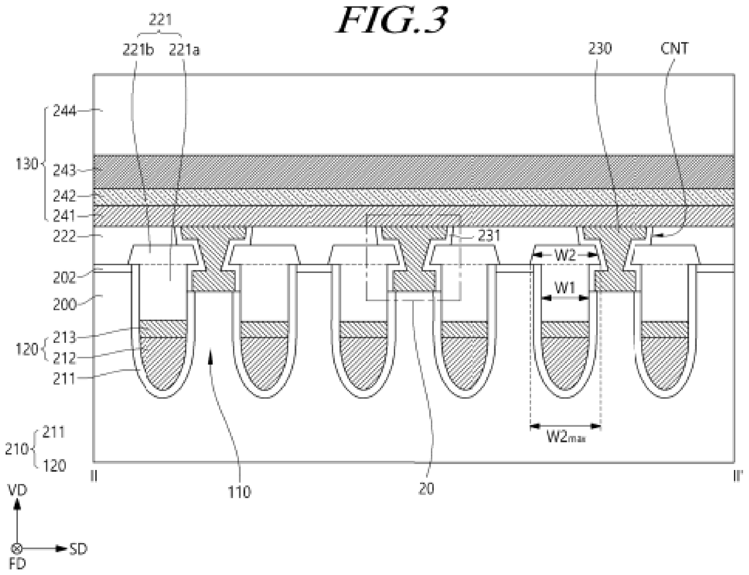

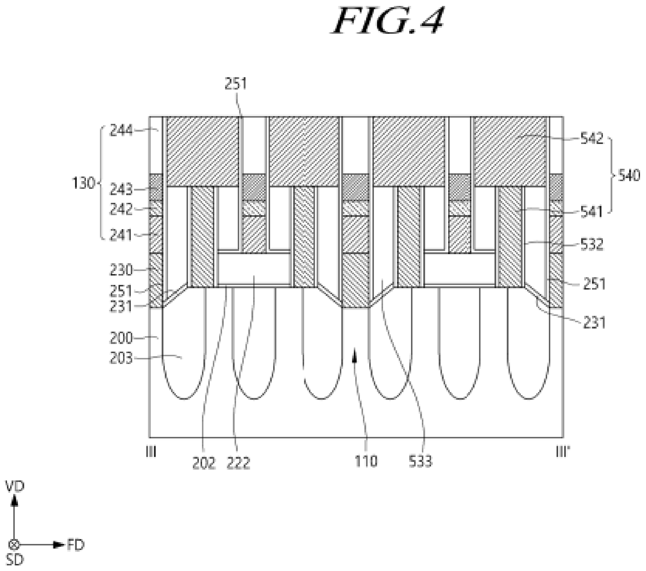

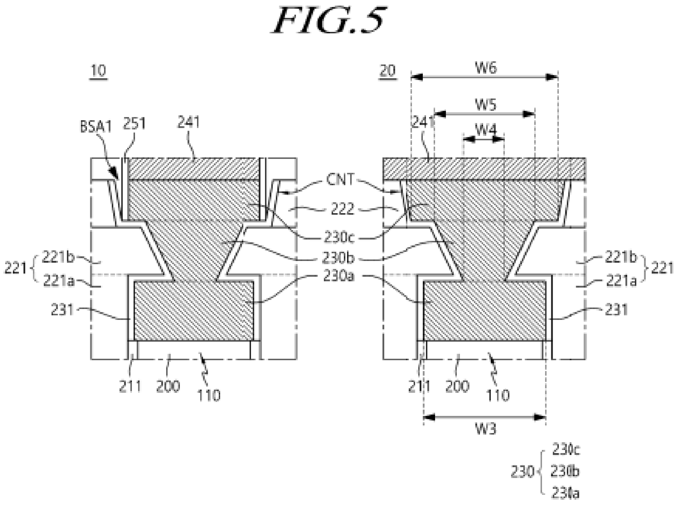

FIG. 2 is a view illustrating a cross-sectional structure of part I-I' of FIG. 1. FIG. 3 is a view illustrating a cross-sectional structure of part II-II' of FIG. 1. FIG. 4 is a view illustrating a cross-sectional structure of part III-III' of FIG. 1. FIGS. 5 to 7 are enlarged views of portion 10 of FIG. 1 and portion 20 of FIG. 2.

Referring to FIGS. 2 and 5, a memory device according to embodiments of the present disclosure includes a substrate 200, an element isolation layer 203, a gate structure 210, a first insulation layer 202, a gate capping layer 221, a buffer layer 222, a first spacer 231, a bit line contact 230, a bit line structure 130, and a bit line spacer 251.

The substrate 200 may include a semiconductor substrate such as a silicon wafer or a silicon on insulator (SOI) wafer. The substrate 200 may include a group III-V semiconductor substrate, e.g., a compound semiconductor substrate such as gallium arsenide (GaAs). The substrate 200 may include monocrystalline silicon, polysilicon, amorphous silicon, monocrystalline silicon germanium, polycrystalline silicon germanium, carbon-doped silicon, or a combination thereof.

The element isolation layer 203 limiting the active area 110 may be disposed in the substrate 200. The active areas 110 may be spaced apart from each other in the first direction FD, the second direction SD, and the third direction TD by the element isolation layer 203. The active area 110 and the element isolation layer 203 may be formed using a trench element isolation technology such as shallow trench isolation (STI). In an embodiment, the active area 110 may include single crystalline silicon having P-type impurities. The P-type impurities may include boron (B), boron trifluoride (BF3), boron difluoride (BF2), or a combination thereof. The element isolation layer 203 may include a single layer or multiple layers. The element isolation layer 203 may include at least two selected from the group consisting of Silicon (Si), Oxygen (O), Nitrogen (N), Carbon (C), and Hydrogen (H). The element isolation layer 203 may include, for example, silicon oxide, silicon nitride, silicon oxynitride, low-K dielectrics, high-K dielectrics, or a combination thereof.

The gate structure 210 is buried in the substrate 200. The gate structure 210 may include a gate insulation layer 211 and a word line 120. The gate insulation layer 211 may surround the side surface and the lower surface of the word line 120. The upper surface of the gate insulation layer 211 may be present at a position higher than the upper surface of the word line 120. However, the embodiments may not be limited thereto, and the upper surface of the gate insulation layer 211 may be positioned at the same height as the upper surface of the word line 120 or at a lower height than the upper surface of the word line 120. The word line 120 may include an upper word line 213 and a lower word line 212. The word line 120 may be positioned lower in a vertical direction than the upper surface of the active area 110.

The gate insulation layer 211 may include, for example, silicon oxide, silicon nitride, silicon oxynitride, high-K dielectric, or a combination thereof. The word line 120 may include a conductive material such as metal, metal oxide, metal nitride, metal silicide, polysilicon, conductive carbon, or a combination thereof. The upper word line 213 may include a material different from the material forming the lower word line 212. In an embodiment, the upper word line 213 may include a low work function material, and the lower word line 212 may include a high work function material. For example, the upper word line 213 may include doped polysilicon, and the lower word line 212 may include titanium nitride.

A first insulation layer 202 may be disposed on the active area 110. In an embodiment, the first insulation layer 202 may include a material such as ultra-low temperature oxide (ULTO).

The gate capping layer 221 may be disposed on the word line 120. The gate capping layer 221 may overlap with word line 120. In an embodiment, each of the gate capping layers 221 may correspond to one word line 120. The gate capping layer 221 may include a first capping portion 221a and a second capping portion 221b.

The first capping portion 221a contacts an upper surface of the upper word line 213. In an embodiment, the first capping portion 221a may fill a space between the inner surfaces of the gate insulation layer 211.

In another embodiment, the first capping portion 221a may be disposed on the gate insulation layer 211. For example, when the upper surface of the gate insulation layer 211 is positioned at the same height as the upper surface of the upper word line 213, the first capping portion 221a may be disposed on the gate insulation layer 211 and the upper word line 123. In this case, the first capping portion 221a may fill a space between the active areas 110 and a space between the inner surfaces of the first insulation layer 202.

In an embodiment, a lower surface of the first capping portion 221a may be positioned higher than an upper surface of the substrate 200.

The second capping portion 221b may be disposed on the first capping portion 221a. The second capping portion 221b is continuous to the first capping portion 221a. A width of the second capping portion 221b may be different from a width of the first capping portion 221a. A width of the second capping portion 221b is described below with reference to FIG. 3. In an embodiment, the lower surface of the second capping portion 221b may contact the upper surface of the gate insulation layer 211. In an embodiment, a lower surface of the second capping portion 221b may contact an upper surface of the first insulation layer 202.

The gate capping layer 221 may include, for example, silicon oxide, silicon nitride, silicon oxynitride, low-K dielectrics, high-K dielectrics, or a combination thereof. In an embodiment, the gate capping layer 221 may include, for example, silicon nitride.

The buffer layer 222 may be disposed on the first insulation layer 202, the element isolation layer 203, the gate insulation layer 211, and the gate capping layer 221. The buffer layer 222 fills a space between the gate capping layers 221 corresponding to different word lines 120, respectively. The buffer layer 222 may contact an upper surface of the first insulation layer 202. The buffer layer 222 covers the second capping portion 221b of the gate capping layer 221. The buffer layer 222 contacts the upper and side surfaces of the second capping portion 221b of the gate capping layer 221.

The buffer layer 222 may include, for example, silicon oxide, silicon nitride, silicon oxynitride, low-K dielectric, high-K dielectric, or a combination thereof. For example, the buffer layer 222 may include SiCOH, SiCO, SiO2, SiCN, or a combination thereof. Alternatively, the buffer layer 222 may include a material such as ultra-low temperature oxide (ULTO) or spin on dielectric (SOD) depending on how it is deposited. In an embodiment, the buffer layer 222 may include a material having etch selectivity with respect to the gate capping layer 221 and the first bit line 241.

Referring to FIGS. 1, 2, and 5, a bit line contact hole CNT may be disposed between the word lines 120. The bit line contact hole CNT may be a space formed by etching the buffer layer 222, the first insulation layer 202, and the gate insulation layer 211. In an embodiment, the bit line contact hole CNT may overlap with gate capping layer 221 and the word line 120. The bit line contact hole CNT exposes the active area 110 of the substrate 200 between the word lines 120.

A first spacer 231 may be disposed along a side surface of the bit line contact hole CNT. In an embodiment, the first spacer 231 may conformally cover a side surface of the bit line contact hole CNT. The first spacer 231 surrounds a side surface of the bit line contact 230. The first spacer 231 may include, for example, silicon nitride.

The bit line contact 230 penetrates the buffer layer 222 and the first insulation layer 202 to contact the active area 110 of the substrate 200. In an embodiment, a side surface facing the word line 120, among the side surfaces of the bit line contact 230 may have a concave shape toward the center of the bit line contact 230. The side surface of the bit line contact 230 may be concave in a direction facing the second capping portion 221b of the gate capping layer 221. In an embodiment, the width of the bit line contact 230 may be the smallest in an area adjacent to the lower surface of the second capping portion 221b. The bit line contact 230 may include a conductive material such as metal, metal oxide, metal nitride, metal silicide, polysilicon, conductive carbon, or a combination thereof. A detailed structure of the bit line contact 230 is described below with reference to FIG. 3.

The bit line structure 130 may be disposed on the bit line contact 230. The bit line structure 130 may include a first bit line 241, a second bit line 242, a third bit line 243, and a bit line capping layer 244. The first bit line 241, the second bit line 242, the third bit line 243, and the bit line capping layer 244 are sequentially stacked in the vertical direction. The first bit line 241, the second bit line 242, and the third bit line 243 may constitute one bit line. The first bit line 241, the second bit line 242, and the third bit line 243 may include a conductive material such as metal, metal oxide, metal nitride, metal silicide, polysilicon, conductive carbon, or a combination thereof. The bit line capping layer 244 may include, for example, silicon oxide, silicon nitride, silicon oxynitride, low-K dielectric, high-K dielectric, or a combination thereof. In an embodiment, the first bit line 241 may be polysilicon, the second bit line 242 may be metal silicide, and the third bit line 243 may be metal. In an embodiment, the bit line capping layer 244 may be silicon nitride.

A bit line spacer 251 may be disposed on the side surfaces of the bit line contact 230 and the bit line structure 130. The bit line spacer 251 may include, for example, silicon nitride. An insulation material may fill a space BSA1 between the bit line spacer 251 and the first spacer 231.

Referring to FIGS. 1, 3, and 5, the gate capping layer 221 may extend along the first direction FD. The gate capping layer 221 may be disposed spaced apart from each other in the second direction SD.

In an embodiment, the width W2 in the second direction SD of the second capping portion 221b of the gate capping layer 221 may decrease away from the upper surface of the substrate 200 in the vertical direction. For example, the cross section of the second capping portion 221b may have a trapezoidal shape in which the width of the lower surface is greater than the width of the upper surface. However, the cross section of the second capping portion 221b is not limited thereto, and the cross section of the second capping portion 221b may have various shapes, such as a rectangular shape and a semicircular shape.

In an embodiment, the second capping portion 221b may have a maximum width W2ₘₐₓ on a lower surface thereof. In an embodiment, the maximum width W2ₘₐₓ of the second capping portion 221b may be greater than the width W1 of the first capping portion 221a in the second direction SD. The second capping portion 221b may further protrude in the second direction SD than the first capping portion 221a. The second capping portion 221b may extend toward the concave side surface of the bit line contact 230 in the second direction SD.

Referring to FIGS. 3 and 5, the bit line contact 230 may include a first contact portion 230a, a second contact portion 230b, and a third contact portion 230c.

The first contact portion 230a contacts the active area of the substrate 200. The first contact portion 230a may overlap with first capping portion 221a of the gate capping layer 221 in the second direction SD. The width W3 in the second direction SD of the first contact portion 230a may be constant. For example, the width of the lower surface of the first contact portion 230a may be the same as the width of the upper surface.

The second contact portion 230b may be disposed on the first contact portion 230a. The second contact portion 230b is continuous to the first contact portion 230a. The second contact portion 230b may overlap with second capping portion 221b of the gate capping layer 221 in the second direction SD. In an embodiment, a width W4 of the lower surface of the second contact portion 230b may be less than a width W3 of the upper surface of the first contact portion 230a. In an embodiment, the width of the second contact portion 230b may be the thinnest on the lower surface. In an embodiment, the shape of the second contact portion 230b may vary according to the shape of the second capping portion 221b of the gate capping layer 221.

The third contact portion 230c may be disposed on the second contact portion 230b. The third contact portion 230c is continuous to the second contact portion 230b. The third contact portion 230c may be positioned higher than the second capping portion 221b of the gate capping layer 221. In an embodiment, the lower surface of the third contact portion 230c may be positioned higher than the upper surface of the second capping portion 221b. In an embodiment, a width W6 of the lower surface of the third contact portion 230c in the second direction SD may be greater than a width W5 of the upper surface of the second contact portion 230b in the second direction SD.

In an embodiment, the second capping portion 221b of the gate capping layer 221 may overlap with first contact portion 230a and the third contact portion 230c of the bit line contact 230 in the vertical direction.

Referring to FIG. 4, a memory device according to embodiments of the present disclosure further includes a second spacer 532, a third spacer 533, and a contact plug 540. The contact plug 540 includes a lower contact plug 541 and an upper contact plug 542 disposed on the lower contact plug. The lower contact plug 541 and the upper contact plug 542 may include a conductive material such as metal, metal oxide, metal nitride, metal silicide, polysilicon, conductive carbon, or a combination thereof.

The contact plug 540 contacts the active area 110. In an embodiment, two contact plugs 540 may be positioned between the bit line contacts 230 in the first direction FD. Between the contact plugs 540, a first insulation layer 202 and a buffer layer 222 are disposed under the bit line structure 130. In an embodiment, in the first direction FD, the buffer layer 222 may be positioned between the bit line contacts 230. The second insulation layer 202 and the buffer layer 222 may overlap one element isolation layer 203 in the vertical direction. The lower surface of the first bit line 241 may contact the upper surface of the buffer layer 222. The bit line structure 130 and the contact plug 540 may be alternately disposed in the first direction FD. The bit line spacer 251 may be disposed between the bit line structure 130 and the contact plug 540.

The second spacer 532 may be disposed on the side surface of the lower contact plug 541. The third spacer 533 may be disposed in a space surrounded by the first spacer 231, the second spacer 532, and the bit line spacer 251. The first spacer 231 may extend between the element isolation layer 203 and the third spacer 533. The bit line spacer 251 may extend between the buffer layer 222 and the third spacer 533.

The second and third spacers 532 and 533 may include a dielectric such as, for example, silicon oxide, silicon nitride, silicon oxynitride, low-K dielectric, high-K dielectric, or a combination thereof.

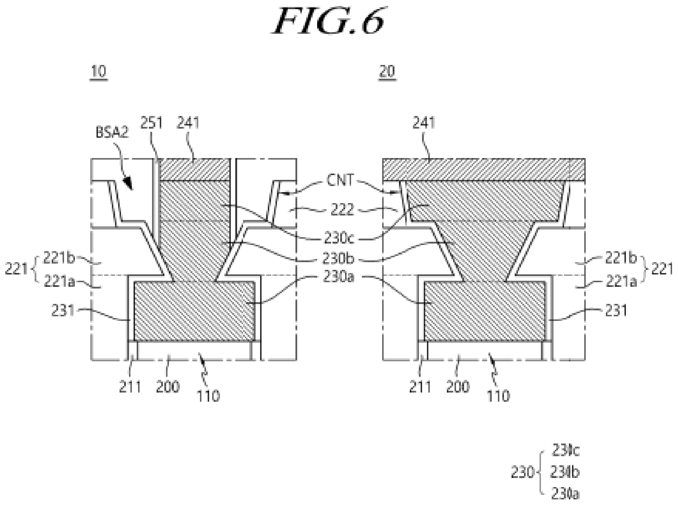

According to the embodiment illustrated in FIGS. 2 and 6, at least a portion of the side surface of the second contact portion 230b of the bit line contact 230 may be spaced apart from the inner surface of the first spacer 231. The bit line spacer 251 may be disposed on the side surfaces of the second contact portion 230b and the third contact portion 230c.

In a direction (e.g., the third direction TD or a direction of extending parallel to the upper surface of the substrate 200 between the first direction FD and the third direction TD) different from the second direction SD, the width of the third contact portion 230c of the bit line contact 230 may be less than the width of the third contact portion 230c of the bit line contact 230 of FIG. 5. In a direction (e.g., the third direction TD or a direction of extending parallel to the upper surface of the substrate 200 between the first direction FD and the third direction TD) different from the second direction SD, the width of the upper surface of the second contact portion 230b of the bit line contact 230 may be substantially the same as the width of the lower surface of the third contact portion 230c. An insulation material may fill a space BSA2 between the bit line spacer 251 and the first spacer 231.

Referring to FIGS. 3 and 6, the width of the third contact portion 230c of the bit line contact 230 in the second direction SD may be substantially the same as the width of the third contact portion 230c of the bit line contact 230 shown in FIG. 5. In the second direction SD, the width of the upper surface of the second contact portion 230b of the bit line contact 230 may be less than the width of the lower surface of the third contact portion 230c.

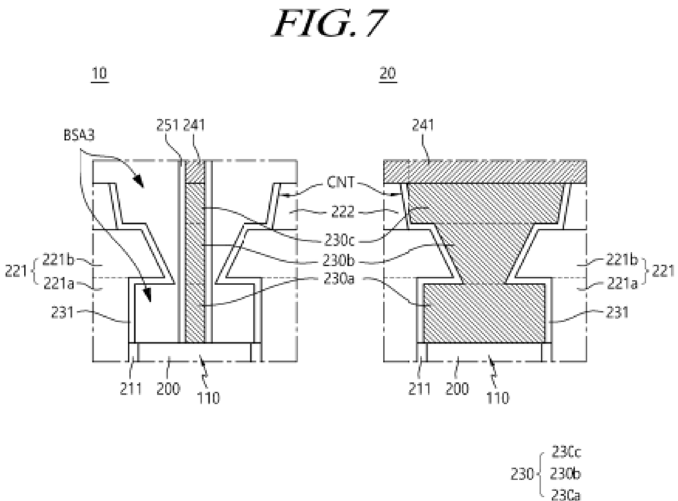

Referring to FIGS. 2 and 7, in an embodiment, a side surface of the second contact portion 230b and a side surface of the first contact portion 230a of the bit line contact 230 may be spaced apart from an inner surface of the first spacer 231. In an embodiment, the bit line spacer 251 may be disposed on the side surfaces of the first contact portion 230a, the second contact portion 230b, and the third contact portion 230c.

In a direction (e.g., the third direction TD or a direction of extending parallel to the upper surface of the substrate 200 between the first direction FD and the third direction TD) different from the second direction SD, the widths of the first contact portion 230a, the second contact portion 230b, and the third contact portion 230c of the bit line contact 230 may be substantially the same. An insulation material may fill a space BSA3 between the bit line spacer 251 and the first spacer 231.

Referring to FIGS. 3 and 7, the widths of the first contact portion 230a, the second contact portion 230b, and the third contact portion 230c of the bit line contact 230 in the second direction SD may be substantially the same as the widths of the first contact portion 230a, the second contact portion 230b, and the third contact portion 230c, respectively, described with reference to FIG. 5.

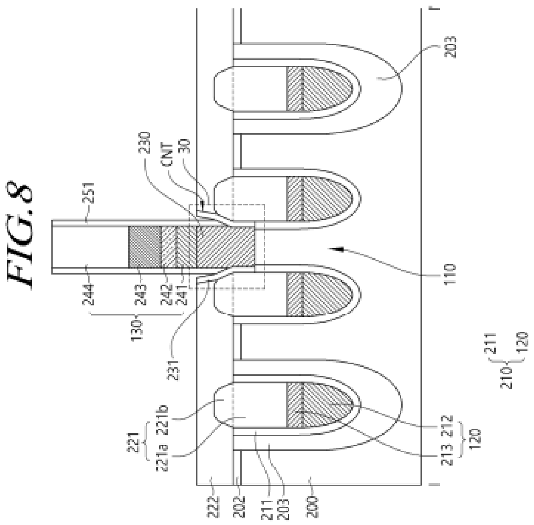

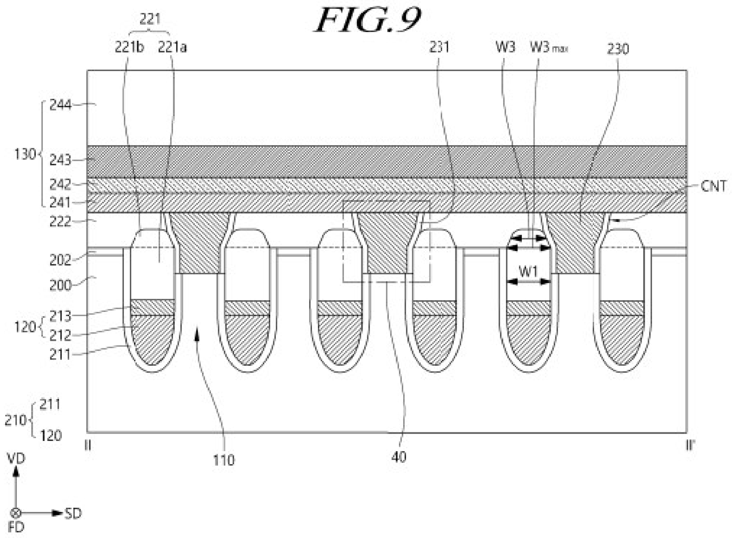

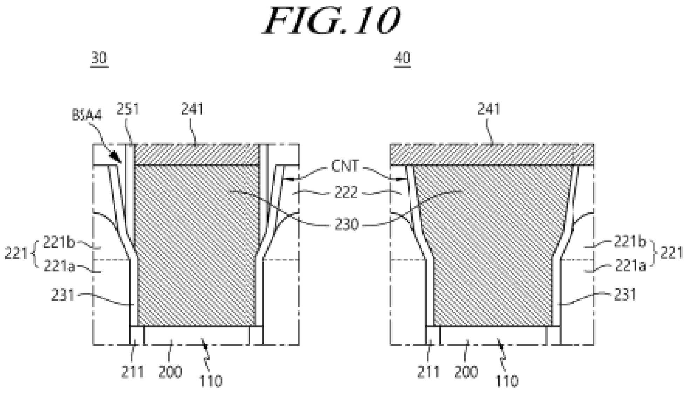

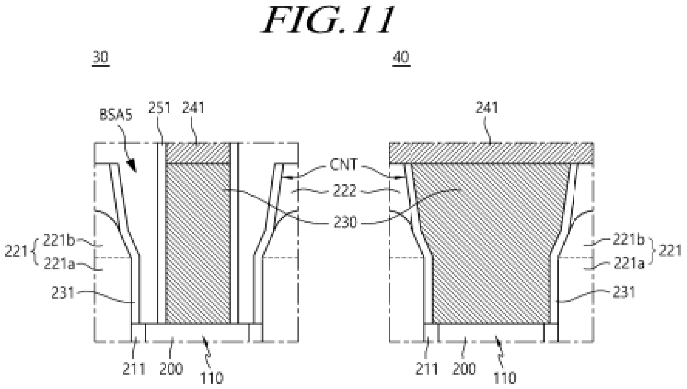

FIG. 8 is a view illustrating another cross-sectional structure of part I-I' of FIG. 1. FIG. 9 is a view illustrating another cross-sectional structure of part II-II' of FIG. 1. FIGS. 10 and 11 are enlarged views of portion 30 of FIG. 8 and portion 40 of FIG. 9.

Referring to FIGS. 8 and 10, a memory device according to embodiments of the present disclosure includes a substrate 200, an element isolation layer 203, a gate structure 210, a first insulation layer 202, a gate capping layer 221, a buffer layer 222, a first spacer 231, a bit line contact 230, a bit line structure 130, and a bit line spacer 251.

The gate capping layer 221 may be disposed on the word line 120. The gate capping layer 221 may overlap with word line 120. In an embodiment, each of the gate capping layers 221 may correspond to one word line 120. The gate capping layer 221 may include a first capping portion 221a and a second capping portion 221b.

The first capping portion 221a may be substantially the same as the first capping portion 221a described with reference to FIG. 2, and may be disposed on the word line 120.

The second capping portion 221b may be disposed on the first capping portion 221a. The second capping portion 221b is continuous to the first capping portion 221a. A width of the second capping portion 221b may be different from a width of the first capping portion 221a. A width of the second capping portion 221b may be decreasing in a direction away from the first capping portion. A width of the second capping portion 221b is described below with reference to FIG. 9. In an embodiment, the lower surface of the second capping portion 221b may be at the same level with the upper surface of the gate insulation layer 211. In an embodiment, the lower surface of the second capping portion 221b may contact the upper surface of the gate insulation layer 211. In an embodiment, a lower surface of the second capping portion 221b may be at the same level with an upper surface of the first insulation layer 202. Referring to FIGS. 1, 8, and 10, a bit line contact hole CNT may be disposed between the word lines 120. In an embodiment, the bit line contact hole CNT may overlap with the gate capping layer 221 and the word line 120. The bit line contact hole CNT exposes the active area 110 of the substrate 200 between the word lines 120.

A first spacer 231 may be disposed along a side surface of the bit line contact hole CNT. In an embodiment, the first spacer 231 may conformally cover a side surface of the bit line contact hole CNT. The first spacer 231 surrounds a side surface of the bit line contact 230. The first spacer 231 may include, for example, silicon nitride.

The bit line contact 230 penetrates the buffer layer 222 and the first insulation layer 202 to contact the active area 110 of the substrate 200. In an embodiment, a side surface facing the word line 120, among the side surfaces of the bit line contact 230 may have a concave shape toward the center of the bit line contact 230. The side surface of the bit line contact 230 may be concave in a direction facing the second capping portion 221b of the gate capping layer 221. In an embodiment, the width of the bit line contact 230 may be the thinnest on the lower surface of the bit line contact 230.

Referring to FIGS. 1, 9, and 10, the gate capping layer 221 may extend along the first direction FD. The gate capping layer 221 may be disposed spaced apart from each other in the second direction SD.

In an embodiment, the width W3 in the second direction SD of the second capping portion 221b of the gate capping layer 221 may decrease away from the upper surface of the substrate 200 in the vertical direction. For example, the cross section of the second capping portion 221b may have a shape in which the width of the lower surface is greater than the width of the upper surface. However, the shape of the cross section of the second capping portion 221b is not limited thereto.

In an embodiment, the second capping portion 221b may have a maximum width W3ₘₐₓ on a lower surface thereof in the second direction SD. In an embodiment, the maximum width W3ₘₐₓ of the second capping portion 221b in the second direction SD may be substantially the same as the width W1 of the first capping portion 221a in the second direction SD. The second capping portion 221b may not further protrude in the second direction SD than the first capping portion 221a. The second capping portion 221b may extend toward the concave side surface of the bit line contact 230 in the second direction SD. An insulation material may fill a space BSA4 between the bit line spacer 251 and the first spacer 231.

Referring to FIGS. 8 and 11, in an embodiment, a side surface of the bit line contact 230 may be spaced apart from an inner surface of the first spacer 231. In an embodiment, the bit line spacer 251 may be disposed on the entire side surface of the bit line contact 230.

In a direction (e.g., the third direction TD or a direction of extending parallel to the upper surface of the substrate 200 between the first direction FD and the third direction TD) different from the second direction SD, the width of the bit line contact 230 may be less than the width of the bit line contact 230 shown in FIG. 10. In a direction (e.g., the third direction TD or a direction of extending parallel to the upper surface of the substrate 200 between the first direction FD and the third direction TD) different from the second direction SD, the width of the bit line contact 230 may be constant. For example, the widths of the upper and lower surfaces of the bit line contact 230 may be substantially the same. An insulation material may fill a space BSA5 between the bit line spacer 251 and the first spacer 231.

Referring to FIGS. 9 and 11, the width of the bit line contact 230 in the second direction SD may be substantially the same as the width of the bit line contact 230 shown in FIG. 10. For example, the width of the upper surface of the bit line contact 230 in the second direction SD may be greater than the width of the lower surface.

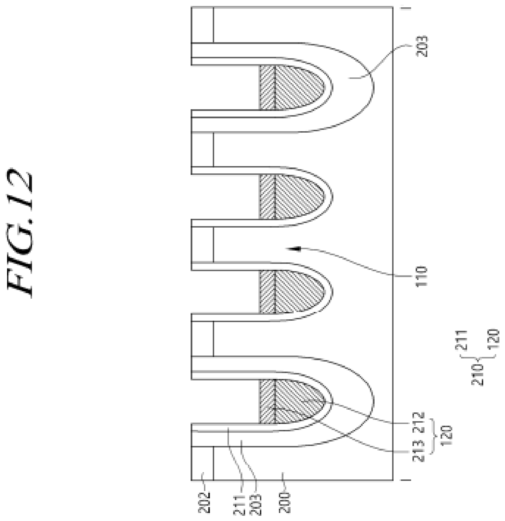

FIGS. 12 to 21 are views illustrating a method for manufacturing a memory device according to embodiments of the present disclosure.

Referring to FIG. 12, a substrate 200 having an element isolation layer 203 limiting the active area 110 of the substrate 200, a gate structure 210 buried in the substrate 200, and a first insulation layer 202 is provided.

The first insulation layer 202 may be formed before the gate structure 210. For example, as the first insulation layer 202 may be formed on the substrate 200, upper portions of the first insulation layer 202 and the substrate 200 may be removed, forming a trench in which the gate structure 210 may be disposed. In an embodiment, the thickness of the first insulation layer 202 may be 100 angstroms or more and 300 angstroms or less.

Thereafter, the gate structure 210 may be formed on the side surface and the lower surface of the trench. The gate structure 210 may be formed in the element isolation layer 203 or in the active area 110 of the substrate 200. In FIG. 12, the gate insulation layer 211 is illustrated as formed on the side surface of the first insulation layer 202 and the side surface of the element isolation layer 203, but the embodiment is not necessarily limited thereto. For example, the upper surface of the gate insulation layer 211 may be formed to be positioned below the upper surface of the upper word line 213.

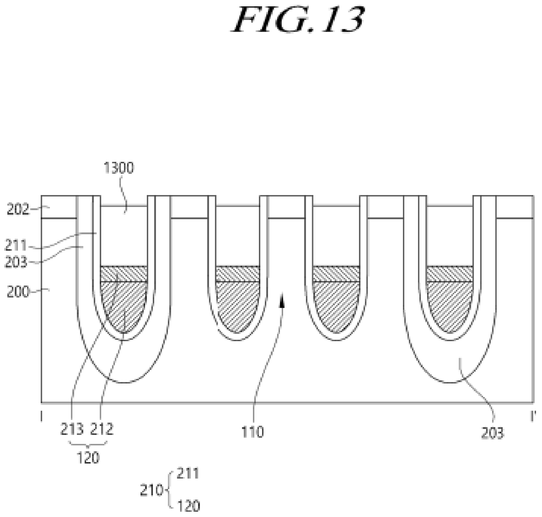

Referring to FIG. 13, a first gate capping material 1300 may be formed on the word line 120. The first gate capping material 1300 may be formed to correspond to each of the word lines 120. The process of forming the first gate capping material 1300 may include an etch-back process. In the illustrated embodiment of FIG. 13, an upper surface of the first gate capping material 1300 may be positioned lower than an upper surface of the first insulation layer 202. Also, the upper surface of the first gate capping material 1300 may be positioned higher than an upper surface of the substrate 200. The first gate capping material 1300 may include, for example, silicon nitride.

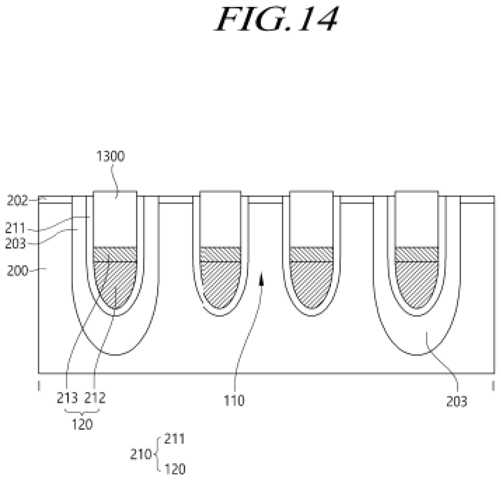

Referring to FIG. 14, portions of the first insulation layer 202, the element isolation layer 203, and the gate insulation layer 211 may be removed to expose an upper part of the side surface of the first gate capping material 1300. The process of removing portions of the first insulation layer 202, the element isolation layer 203, and the gate insulation layer 211 may include an etching process.

In an embodiment, the thickness of the first insulation layer 202 after etching may be 50 angstroms or more and 100 angstroms or less. The upper surface of the first insulation layer 202 may be positioned lower than the upper surface of the first gate capping material 1300.

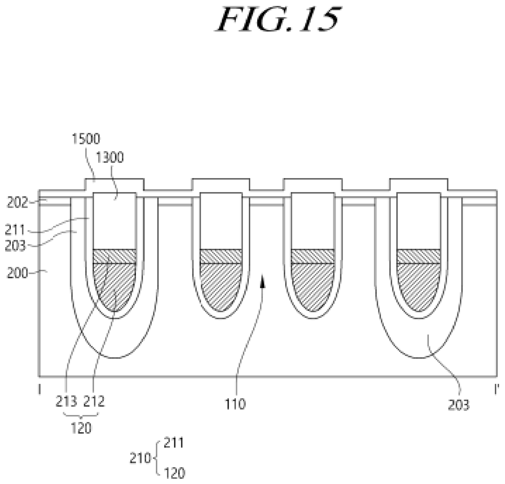

Referring to FIG. 15, the second gate capping material 1500 may be formed on the first insulation layer 202 and on the first gate capping material 1300. The second gate capping material 1500 may be formed along a step of the lower layer. For example, the upper surface of the second gate capping material 1500 in the area where the first gate capping material 1300 may be positioned higher than the upper surface of the second gate capping material 1500 in the area where the first gate capping material 1300 is not disposed.

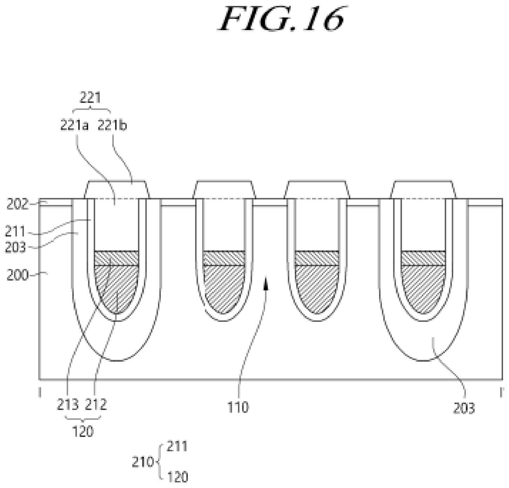

Referring to FIG. 16, at least a portion of the first gate capping material 1300 and the second gate capping material 1500 is removed to form a gate capping layer 221. The process of forming the gate capping layer 221 may include an etching process. At least a portion of the first gate capping material 1300 and the second gate capping material 1500 may be removed to expose an upper surface of the first insulation layer 202.

In an embodiment, the maximum width of the second capping portion 221b of the gate capping layer 221 may be greater than a width of the first capping portion 221a. The side surface of the second capping portion 221b may be tapered with a width of the second capping portion 221b being greater at an interface with the first capping portion 221a.

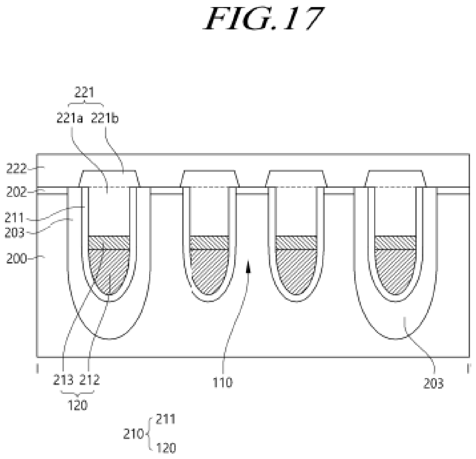

Referring to FIG. 17, a buffer layer 222 may be formed on the gate capping layer 221. The buffer layer 222 may contact an upper surface of the first insulation layer 202. The buffer layer 222 may contact an upper surface and a side surface of the second capping portion 221b of the gate capping layer 221.

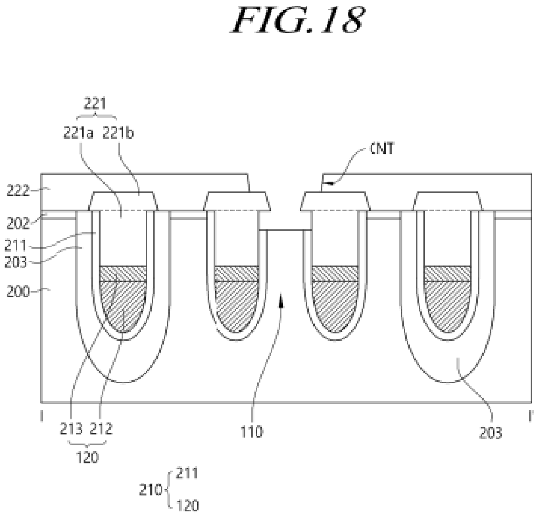

Referring to FIG. 18, upper portions of the buffer layer 222, the first insulation layer 202, and the substrate 200 are removed in the regions between the gate capping layer 221 to form bit line contact holes CNT. Each bit line contact hole CNT exposes the active area 110 of the substrate 200. The process of forming the bit line contact hole CNT includes an etching process. In an embodiment of the present disclosure, the process of forming the bit line contact hole CNT may include a self-aligned contact etching process using etch selectivity between the buffer layer 222 and the gate capping layer 221.

The gas used in the etching process may include a material capable of increasing the etching selectivity between the gate capping layer 221 and the buffer layer 222. In an embodiment, the gas used in the etching process may include a CxFy based material with x and y being natural numbers. Here, the value obtained by dividing y by x may be greater than or equal to 1.5. In an embodiment, the gas used in the dry etching process may be C4F6 (hexafluorobutadiene).

In the process of forming the bit line contact hole CNT, the gate capping layer 221 may remain unetched. For example, after the bit line contact hole CNT is formed, the second capping portion 221b of the gate capping layer 221 may protrude further outward than the buffer layer 222. The width of the upper surface of the second capping portion 221b of the gate capping layer 221 may be substantially the same as the width of the upper surface of the capping portion 221b before the bit line contact hole CNT is formed.

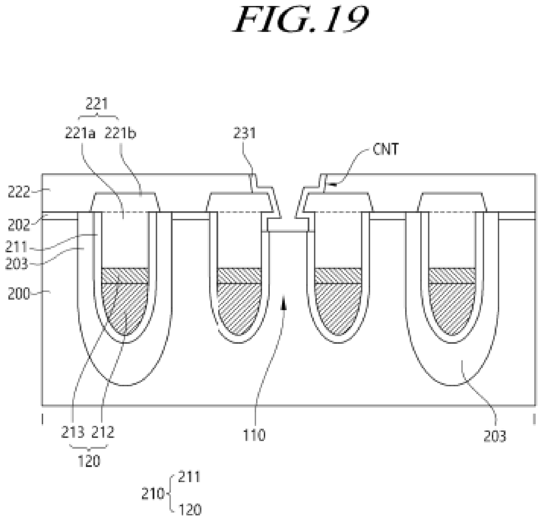

Referring to FIG. 19, a first spacer 231 may be formed on a side surface and a lower surface of the bit line contact hole CNT. In an embodiment, the first spacer 231 may be conformally formed on a side surface and a lower surface of the bit line contact hole CNT. Thereafter, the first spacer 231 positioned on the lower surface of the bit line contact hole CNT may be removed to expose the active area 110 of the substrate 200.

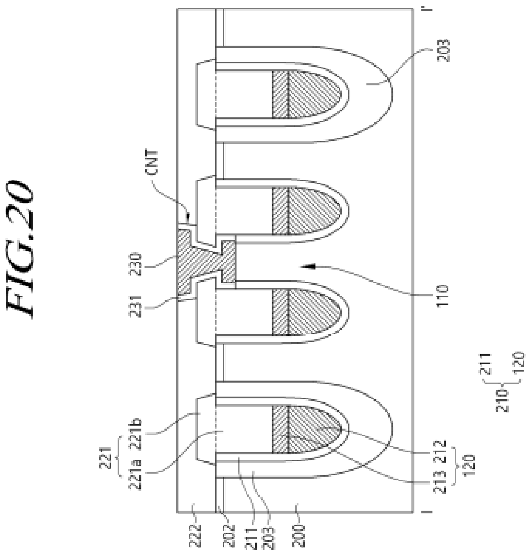

Referring to FIG. 20, a bit line contact 230 may be formed in the bit line contact hole CNT. The process of forming the bit line contact 230 may include a process of depositing a conductive material and an etch-back process. The upper surface of the bit line contact 230 may form substantially the same plane as the upper surface of the buffer layer 222. The lower surface of the bit line contact 230 may contact the active area 110 of the substrate 200.

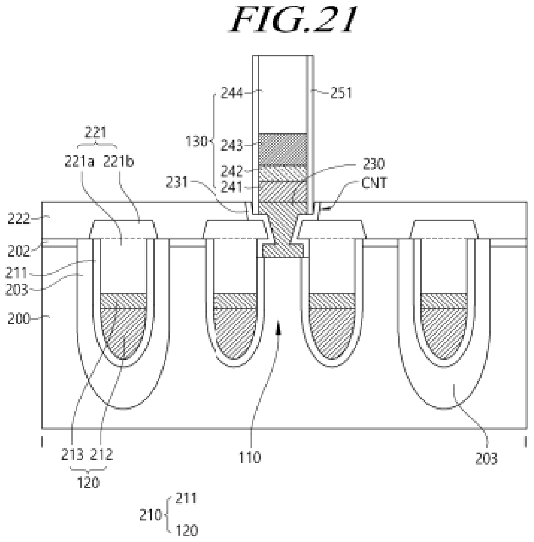

Referring to FIG. 21, a first bit line 241, a second bit line 242, a third bit line 243, and a bit line capping layer 244 may be formed sequentially on the bit line contact 230 and the buffer layer 222. The process of forming the first bit line 241, the second bit line 242, the third bit line 243, and the bit line capping layer 244 may include an etching process. In an embodiment, at least a portion of the bit line contact 230 may be etched together by the etching process. Referring back to FIG. 5, in an embodiment, at least a portion of the side surface of the third contact portion 230c of the bit line contact 230 may be spaced apart from the first spacer 231.

A bit line spacer 251 may be formed on the side surfaces of the first bit line 241, the second bit line 242, the third bit line 243, and the bit line capping layer 244. In an embodiment, the bit line spacer 251 may extend to a place lower than the upper surface of the buffer layer 222.

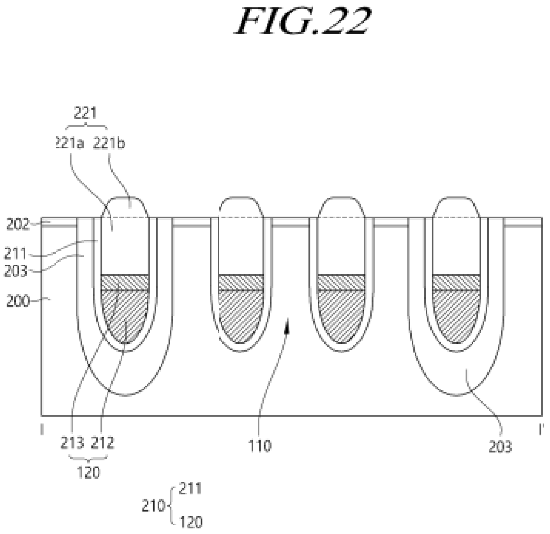

FIG. 22 is a view illustrating another method for manufacturing a memory device according to embodiments of the present disclosure.

The memory device illustrated in FIG. 22 may be formed by the same method as the method for manufacturing the memory device described with reference to FIGS. 12 to 15.

Referring to FIGS. 15 and 22, at least a portion of the first gate capping material 1300 and the second gate capping material 1500 is removed to form a gate capping layer 221. The process of forming the gate capping layer 221 may include an etching process. At least a portion of the first gate capping material 1300 and the second gate capping material 1500 may be removed to expose an upper surface of the first insulation layer 202.

In an embodiment as illustrated in FIG. 22, a maximum width of the second capping portion 221b of the gate capping layer 221 may be the same as a width of the first capping portion 221a.

Referring back to FIG. 8, a buffer layer 222, a first spacer 231, a bit line contact 230, a bit line structure 130, and a bit line spacer 251 may be formed on the gate capping layer 221. The process of forming the buffer layer 222, the first spacer 231, the bit line contact 230, the bit line structure 130, and the bit line spacer 251 may be substantially the same as the process of forming the buffer layer 222, the first spacer 231, the bit line contact 230, the bit line structure 130, and the bit line spacer 251 described with reference to FIGS. 17 to 21.

Referring back to FIGS. 2, 3 and 5, the gate capping layer 221 may include a first capping portion 221a disposed on the word line 120 and a second capping portion 221b disposed on the first capping portion 221a, extending toward a concave side of the bit line contact 230, and having a width different from that of the first capping portion 221a. A side surface facing the word line 120, among the side surfaces of the bit line contact 230 may be concave toward the center of the bit line contact 230. In an embodiment, the process of forming the bit line contact hole CNT may include a self-aligned contact etching process using etch selectivity between the buffer layer 222 and the gate capping layer 221. In an embodiment, the gate capping layer 221 may include nitride, and the buffer layer 222 may include oxide.

According to embodiments of the present disclosure, only the buffer layer 222 may be selectively etched as an etching process is used to increase an etching selectivity between the gate capping layer 221 and the buffer layer 222 when the bit line contact hole CNT is formed. The gate capping layer 221 may not be etched around the bit line contact hole CNT. Accordingly, the bit line contact 230 and the word line 120 may be prevented from becoming shorted as the gate capping layer 221 is etched during the formation of the bit line contact hole CNT.

Referring back to FIG. 4, the buffer layer 222 may be disposed under the bit line structure 130. The buffer layer 222 may include SiCOH, SiCO, SiO2, SiCN, or a combination thereof. Alternatively, the buffer layer 222 may include a material such as ultra-low temperature oxide (ULTO) or spin on dielectric (SOD) depending on how it is deposited. The buffer layer 222 may include a material having etch selectivity with respect to the first bit line 241, the second bit line 242, and the third bit line 243.

According to embodiments of the present disclosure, since the buffer layer 222 includes a material having etch selectivity with respect to the first bit line 241, the second bit line 242, and the third bit line 243, the buffer layer 222 may not be etched together when the first bit line 241, the second bit line 242, and the third bit line 243 are formed. Therefore, when the first bit line 241, the second bit line 242, and the third bit line 243 are formed, a defect in which the area in which the contact plug 540 is landed is not opened due to etching residues may be prevented.

Further, the buffer layer 222 has higher insulation performance than the gate capping layer 221. As the buffer layer 222 is disposed around the bit line contact 230, it is possible to prevent the bit line contact 230 and the structure (e.g., the contact plug 540) around the bit line contact 230 from being shorted when an ion implementing process for increasing the conductivity of the bit line contact 230 is performed.

The above-described embodiments are merely examples, and it will be appreciated by one of ordinary skill in the art that various changes may be made thereto without departing from the scope of the present disclosure. Accordingly, the embodiments set forth herein are provided for illustrative purposes, but not to limit the scope of the present disclosure, and it should be appreciated that the scope of the present disclosure is not limited by the embodiments. Furthermore, the embodiments may be combined to form additional embodiments.

## Claims

1. A memory device comprising:
a word line buried in a substrate, the word line extending in a first direction;
a bit line contact disposed between word lines, the bit line contact contacting an active area of the substrate, and the bit line contact having at least a portion of a side surface concave toward a center in a second direction perpendicular to the first direction; and
a gate capping layer including a first capping portion contacting an upper surface of the word line and a second capping portion positioned on the first capping portion, overlapping with at least a portion of the side surface of the bit line contact in the second direction, and having a width different from a width of the first capping portion.

2. The memory device of claim 1, wherein a maximum width of the second capping portion of the gate capping layer is greater than the width of the first capping portion.

3. The memory device of claim 2, wherein the bit line contact includes:
a first contact portion contacting the active area of the substrate;
a second contact portion positioned on the first contact portion and overlapping with second capping portion of the gate capping layer in the second direction; and
a third contact portion positioned on the second contact portion, and wherein a width of an upper surface of the first contact portion is greater than a width of a lower surface of the second contact portion.

4. The memory device of claim 3, wherein a width of an upper surface of the second contact portion of the bit line contact is less than a width of a lower surface of the third contact portion.

5. The memory device of claim 3, wherein the second capping portion of the gate capping layer overlaps with the first contact portion and the third contact portion of the bit line contact.

6. The memory device of claim 1, wherein a maximum width of the second capping portion of the gate capping layer is substantially the same as the width of the first capping portion.

7. The memory device of claim 1, further comprising a bit line spacer surrounding the bit line contact, wherein the bit line spacer contacts an upper surface of the second capping portion of the gate capping layer.

8. The memory device of claim 1, wherein a lower surface of the second capping portion of the gate capping layer is positioned higher than an upper surface of the substrate.

9. The memory device of claim 1, further comprising a buffer layer disposed on the gate capping layer, wherein the buffer layer surrounds the bit line contact.

10. The memory device of claim 9, wherein the buffer layer includes oxide, and the gate capping layer includes nitride.

11. A memory device comprising:
a word line buried in a substrate, the word line extending in a first direction;
a bit line contact disposed between word lines, the bit line contact contacting an active area of the substrate, and the bit line contact having at least a portion of a side surface concave toward a center in a second direction perpendicular to the first direction;
a gate capping layer overlapping with word line and having at least a portion overlapping with at least a portion of the side surface of the bit line contact in the second direction; and
a buffer layer disposed on the gate capping layer and surrounding the bit line contact.

12. The memory device of claim 11, wherein the bit line contact includes:
a first contact portion contacting the active area of the substrate;
a second contact portion positioned on the first contact portion and overlapping with at least a portion of the gate capping layer in the second direction; and
a third contact portion positioned on the second contact portion, and wherein a width of an upper surface of the first contact portion is greater than a width of a lower surface of the second contact portion.

13. The memory device of claim 12, wherein a width of an upper surface of the second contact portion of the bit line contact is less than a width of a lower surface of the third contact portion.

14. The memory device of claim 11, wherein the gate capping layer may include a first capping portion contacting an upper surface of the word line and a second capping portion positioned on the first capping portion, overlapping with at least a portion of the side surface of the bit line contact in the second direction, and having a width different from a width of the first capping portion.

15. The memory device of claim 14, wherein a maximum width of the second capping portion of the gate capping layer is greater than the width of the first capping portion.

16. The memory device of claim 14, wherein a maximum width of the second capping portion of the gate capping layer is substantially the same as the width of the first capping portion.

17. The memory device of claim 14, wherein a lower surface of the second capping portion of the gate capping layer is positioned higher than an upper surface of the substrate.

18. The memory device of claim 11, further comprising a bit line spacer surrounding the bit line contact, wherein the bit line spacer contacts a side surface of the buffer layer and an upper surface of the gate capping layer.

19. The memory device of claim 11, wherein the buffer layer includes oxide, and the gate capping layer includes nitride.

20. A memory device comprising:
a word line buried in a substrate and extending in a first direction;
a bit line contact disposed between word lines and contacting an active area of the substrate;
a gate capping layer including a first capping portion contacting an upper surface of the word line and a second capping portion positioned on the first capping portion, a lower surface of the second capping portion being positioned higher than an upper surface of the substrate; and
a buffer layer covering the second capping portion of the gate capping layer and surrounding the bit line contact.
